# EUROPEAN PATENT APPLICATION

(11) **EP 4 213 223 A1**
(43) Date of publication of application: **19.07.2023**
(21) Application number: 22205469.4
(22) Date of filing: 04.11.2022
(51) Int. Cl.: H01L 31/05, H01L 31/0224

(54) **SOLAR MODULE**

(30) Priority: 13.01.2022 CN 202210037575
(71) Applicant: Zhejiang Jinko Solar Co., Ltd., Haining, Zhejiang 314416 (CN); JINKO SOLAR CO., LTD., Jiangxi 334100 (CN)
(72) Inventor: GUO, Zhiqiu, HAINING, 314416 (CN); HAO, Guohui, HAINING, 314416 (CN); HUANG, Shiliang, HAINING, 314416 (CN); ZHANG, Ningbo, HAINING, 314416 (CN); ZHANG, Hengshuo, HAINING, 314416 (CN)
(74) Representative: Spachmann, Holger

(57) **Abstract**

The present disclosure discloses a solar module, including solar cells, each solar cell includes a front surface and a rear surface arranged opposite to each other. The solar cell includes a semiconductor substrate and busbars located on one side of the semiconductor substrate, first electrode pads are provided at the busbars, a number of the first electrode pads ranges from 6 to 12. The solar module includes an electrode line with one end connected to the first electrode pads of the busbars on front surface of the solar cell and the other end connected to the first electrode pads of the busbars on rear surface of the adjacent solar cell. A relation between a diameter of the electrode line and a number of the busbars is 116.55x²-92.03x+27.35<y<582.75x²-425.59x+92.58, x denotes the diameter of the electrode line, and y denotes the number of the busbars.

## Description

### TECHNICAL FIELD

The present disclosure relates to the technical field of photovoltaics, and in particular, to a solar module.

### BACKGROUND

At present, photovoltaic modules are developed vigorously in China. Current mainstream photovoltaic modules in the industry mostly adopt a sandwich structure of "glass/encapsulation material/solar cell/encapsulation material/back sheet". The solar cell is a core component of the photovoltaic module, which is a photoelectric semiconductor sheet that can directly generate power by using sunlight, and also known as a "solar chip" or "photocell".

With the development of photovoltaic technologies, there are more and more types of solar cells and power is gradually increased, but the solar module in the related art has many problems to be solved, such as high costs or low power.

### SUMMARY

In view of the above, the present disclosure provides a solar module, including a plurality of solar cells, and each of the solar cells includes a front surface and a rear surface arranged opposite to each other;
the solar cell includes a semiconductor substrate and busbars located on one side of the semiconductor substrate, first electrode pads are provided at the busbars, a number of the first electrode pads ranges from 6 to 12; the solar module further includes an electrode line having an end connected to the first electrode pads of the busbars on the front surface of one solar sheet of the solar cells and another end connected to the first electrode pads of the busbars on the rear surface of another one solar sheet of the solar cells that is adjacent to the one solar sheet;
a relation between a diameter of the electrode line and a number of the busbars is 116.55x²-92.03x+27.35<y<582.75x²-425.59x+92.58, where x denotes the diameter of the electrode line, and y denotes the number of the busbars.

In an embodiment, a width of each of the busbars is greater than or equal to 20 µm and less than or equal to 60 µm.

In an embodiment, the diameter of the electrode line is greater than or equal to 0.18 mm and less than or equal to 0.35 mm.

In an embodiment, each of the first electrode pad has any shape including triangular shape, rectangular shape, diamond shape, circular shape, and oval shape, or a combination thereof.

In an embodiment, fingers are provided at one side of the semiconductor substrate, and the fingers are electrically connected to the busbars and intersect with the busbars at intersections; and
the first electrode pad includes first sub-electrode pads and second sub-electrode pads, and each of the first sub-electrode pads is located at an end of each of the busbars, and the second sub-electrode pads are located between the first sub-electrode pads.

In an embodiment, in a direction perpendicular to a plane of the semiconductor substrate, at least part of the second sub-electrode pads do not overlap with the intersection.

In an embodiment, a width of each of the busbars is the same as a width of each of the fingers.

In an embodiment, the semiconductor substrate is an N-type substrate or a P-type substrate.

In an embodiment, a length of each of the first sub-electrode pads in a first direction is greater than or equal to 0.5 mm and less than or equal to 0.8 mm, a width of the each of the first sub-electrode pads in a second direction is greater than or equal to 0.5 mm to 1.2 mm, a length of each of the second sub-electrode pads in the first direction is greater than or equal to 0.05 mm and less than or equal to 0.5 mm, and a width of each of the second sub-electrode pad in the second direction is greater than or equal to 0.4 mm and less than or equal to 0.8 mm, the first direction is parallel to an extension direction of the electrode line, the second direction is perpendicular to the extension direction of the electrode line.

In an embodiment, the semiconductor substrate is the P-type substrate, and the busbars on the rear surface are provided with second electrode pads, and a number of the second electrode pads ranges from 6 to 10, a length of each of the second electrode pads in a first direction is greater than or equal to 1 mm and less than or equal to 2 mm, a width of each the second electrode pads in the second direction is greater than or equal to 2 mm and less than or equal to 3 mm, the first direction is parallel to an extension direction of the electrode line, the second direction is perpendicular to the extension direction of the electrode line.

In an embodiment, the semiconductor substrate is the N-type substrate, and a number of the fingers is greater than or equal to 76 and less than or equal to 98; and widths of the fingers are greater than or equal to 20 µm to 30 µm; or
the semiconductor substrate is the P-type substrate, and a number of the fingers is greater than or equal to 90 and less than or equal to 120; and widths of the fingers are greater than or equal to 20 µm to 30 µm.

In an embodiment, the solar module further includes a front sheet, a first encapsulation layer, a second encapsulation layer, a back sheet, and a connection structure, and the solar cells are located between the first encapsulation layer and the second encapsulation layer, and the solar cells are respectively connected to the first encapsulation layer and the second encapsulation layer through the connection structure.

In an embodiment, the semiconductor substrate of the solar cell is an N-type substrate, and the first encapsulation layer and/or the second encapsulation layer has area density greater than or equal to 250 g/m² and less than or equal to 500 g/m²; or
the semiconductor substrate of the solar cell is a P-type substrate, and the first encapsulation layer and/or the second encapsulation layer has area density greater than or equal to 250 g/m² and less than or equal to 400 g/m².

Other features of the present disclosure and advantages thereof will become clear from the following detailed description of exemplary embodiments of the present disclosure with reference to the accompanying drawings.

### BRIEF DESCRIPTION OF DRAWINGS

The accompanying drawings, which are incorporated in and constitute a part of the specification, illustrate embodiments of the present disclosure and, together with the description, serve to explain the principles of the present disclosure.
- FIG. 1: is a schematic diagram of a three-dimensional structure of a solar module according to the present disclosure;
- FIG. 2: is a schematic diagram of a plane structure of a front surface of a solar cell according to the present disclosure;
- FIG. 3: is a sectional view taken along M-M' in FIG. 1;
- FIG. 4: is a diagram of a relation between a diameter of an electrode line and a number of busbars;
- FIG. 5 to FIG. 8: are diagrams of relations between the diameter of the electrode line, the number of busbars, and power of the solar module;
- FIG. 9 to FIG. 12: are diagrams of relations between the diameter of the electrode line, the number of busbars, and costs of the solar module;
- FIG. 13: is a partially enlarged view of a region A in FIG. 2; and
- FIG. 14: is a schematic diagram of a plane structure of a rear surface of the solar cell according to the present disclosure.

### DESCRIPTION OF EMBODIMENTS

Various exemplary embodiments of the present disclosure are now described in detail with reference to the accompanying drawings. It should be noted that, unless otherwise stated specifically, relative arrangement of the components and steps, the numerical expressions, and the values set forth in the embodiments are not intended to limit the scope of the present disclosure.

The following description of at least one exemplary embodiment is in fact merely illustrative, and in no way constitutes any limitations on the present disclosure and application or use thereof.

Technologies, methods, and devices known to those of ordinary skill in the related art may not be discussed in detail, but where appropriate, such technologies, methods, and devices should be considered as part of the specification.

In all the examples shown and discussed herein, any specific value should be construed as merely illustrative and not as a limitation. Therefore, other examples of exemplary embodiments may have different values.

In some embodiments, similar reference signs and letters denote similar terms in the accompanying drawings, and therefore, once an item is defined in a drawing, there is no need for further discussion in the accompanying drawings.

Sizes of solar cells are become larger and larger, corresponding currents are higher and higher, and internal losses are also increasing. In order to reduce the losses caused by the currents, the number of the busbars may be increased. The increase of the busbars can effectively reduce the internal losses, but the busbars are also gradually increasing. The increase of the busbar may lead to an increase in a proportion of an occlusion area of the solar cell and an increase in consumption of silver paste, which may certainly also lead to an increase in the number of the electrode line used at the end of the module and an increase in the costs.

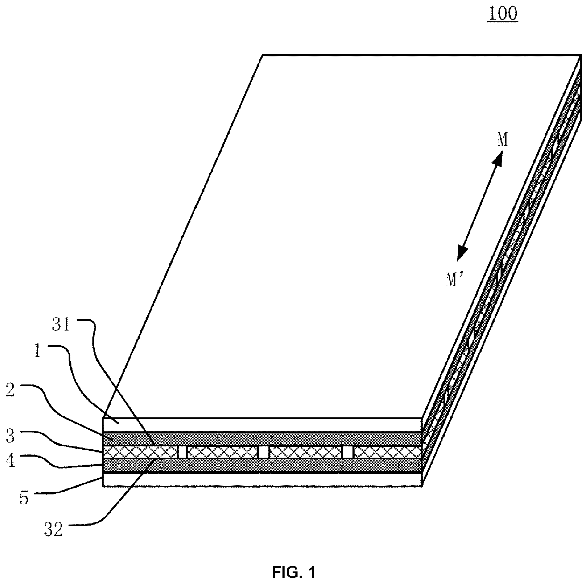

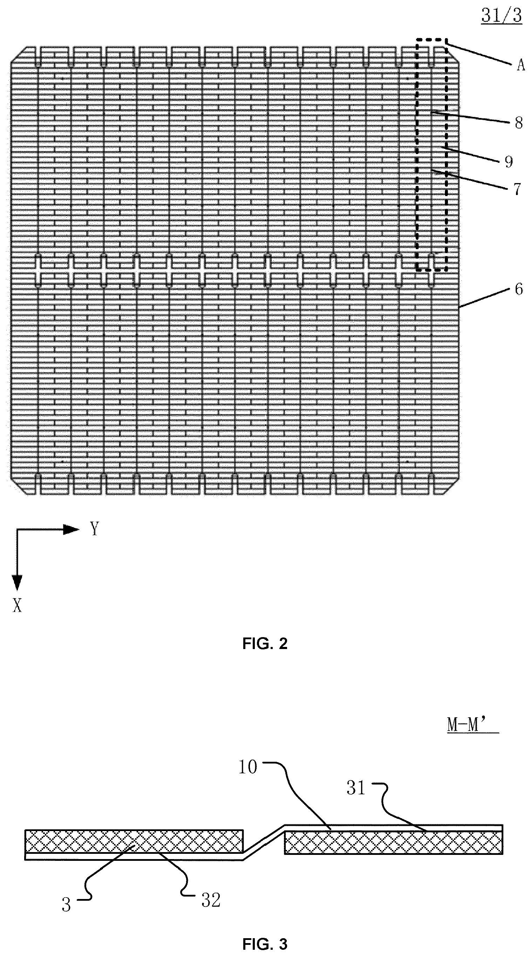

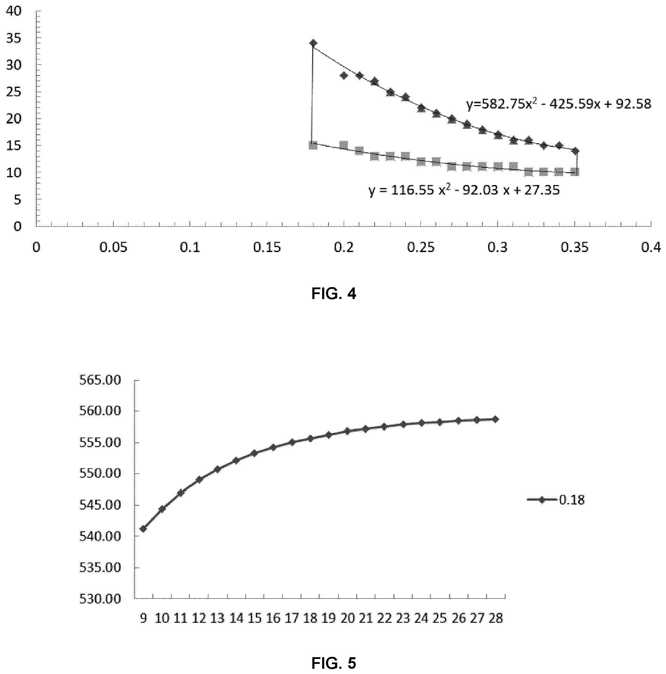

Referring to FIG. 1 and FIG. 2, FIG. 1 is a schematic diagram of a three-dimensional structure of a solar module according to the present disclosure, FIG. 2 is a schematic diagram of a plane structure of a front surface of a solar cell according to the present disclosure, FIG. 3 is a sectional view taken along M-M' in FIG. 1, and FIG. 4 is a diagram of a relation between a diameter of an electrode line and a number of busbars.

Referring to FIG. 1, a solar module 100 in this embodiment includes a plurality of solar cells 3. Each of the solar cells 3 includes a front surface 31 and a rear surface 32 arranged opposite to each other. FIG. 1 only shows that adjacent solar cells 3 are spaced. Certainly, the adjacent solar cells 3 may also be stitch-soldered Stitch-soldering refers to overlapping of ends of two adjacent solar cells 3.

As shown in FIG. 2, the solar cell 3 includes a semiconductor substrate 6 and busbars 7 located on one side of the semiconductor substrate 6. First electrode pads 8 are provided at the busbars 7. A number of the first electrode pads 8 ranges from 6 to 12. Certainly, the number of the first electrode pads 8 on the solar cell 3 may range from 3 to 6.

As shown in FIG. 3, the solar module 100 further includes an electrode line 10. The electrode line 10 has one end connected to the first electrode pads 8 of the busbars 7 on the front surface 31 of the solar cell 3 and the other end connected to the first electrode pads 8 of the busbars 7 on the rear surface 32 of the adjacent solar cell 3.

A relation between a diameter of the electrode line 10 and a number of the busbars 7 is 116.55x²-92.03x+27.35<y<582.75x²-425.59x+92.58, where x denotes the diameter of the electrode line 10, and y denotes the number of the busbars 7.

In an embodiment, the solar module 100 includes a front sheet 1, a first encapsulation layer 2, solar cells 3, a second encapsulation layer 4, and a back sheet 5 that are stacked. The first encapsulation layer 2 is located on the side of the front sheet 1 close to the back sheet 5. The solar cells 3 are located on the side of the first encapsulation layer 2 away from the front sheet 1. The plurality of solar cells 3 are arranged in an array. The second encapsulation layer 4 is located on the side of the solar cells 3 away from the first encapsulation layer 2. The back sheet 5 is located on the side of the second encapsulation layer 4 away from the solar cells 3.

In some embodiments, the front surface 31 and the rear surface 32 are opposite herein. For example, the front surface 31 may be the side that receives sunlight, and the back surface 32 is the side that departs from the sunlight. Alternatively, both the front surface 31 and the rear surface 32 receive the sunlight.

In some embodiments, in the related art, in order to improve efficiency of the solar module 100, half a solar cell or a plurality of solar cells may be used in the photovoltaic module. A whole solar cell is taken as an example in the solution.

In an embodiment, the solar cell 3 in this embodiment may be of any size between 180 mm and 190 mm. That is, a length and a width are both between 180 mm and 190 mm. For example, the size may be 182 mm×182 mm, 184 mm×184 mm, 186 mm×186 mm, 188 mm×188 mm, or 190 mm×190 mm, which may also be other sizes and is not specified herein. In this embodiment, the size of the solar cell 3 is 182 mmx182 mm.

If the solar cell 3 is halved, the electrode line 10 has one end connected to the first electrode pads 8 of the busbars 7 on the front surface 31 of the solar cell 3 and the other end connected to the first electrode pads 8 of the busbars 7 on the rear surface 32 of the adjacent solar cell 3, which is not specified herein.

FIG. 2 only schematically shows the number of the busbars 7, which is not used as a limitation on an actual product herein. In FIG. 2, an extension direction of the busbars 7 is a first direction X, and an arrangement direction of the busbars 7 is a second direction Y.

In an embodiment, two ends of each of the busbars 7 each may have a harpoon structure. The first electrode pads 8 are arranged at the harpoon structures. One end of the electrode line 10 may be connected to the first electrode pads 8 of the harpoon structure on the front surface 31 of the solar cell 3, and the other end of the electrode line 10 may be connected to the first electrode pads 8 of the harpoon structure on the rear surface 32 of the solar cell 3.

In FIG. 4, the abscissa is the diameter of the electrode line 10 (in units of mm), and the ordinate is the number of the busbars 7.

In the present disclosure, costs and power of the photovoltaic module can be balanced. On the one hand, the costs are reduced by reducing the diameter of the electrode line 10, because gram weights of the first encapsulation layer 2 and the second encapsulation layer 4 can be reduced after the diameter of the electrode line 10 is reduced. However, the reduction of the diameter of the electrode line 10 may lead to reduction of a cross-sectional area of current transmission, that is, reduction of the power, so there is a need to increase the number of the electrode line 10 and the number of the busbars. On the other hand, the power of the solar module 100 is increased by increasing the number of the busbars. However, the number of the busbars and the power are not in a linear relationship, that is, the power of the solar module 100 does not increase as the number of the busbars increases, but the power may decrease after the number is increased to an extreme value. This is because the increase in the number of the busbars causes excessive occlusion of light. If a decrease in the occlusion is greater than an increase in the current transmission, the power may be reduced.

It may be understood that, if power (in units of W) of 10 to 28 busbars 7 is calculated under a diameter of a same electrode line 10, an inverted parabola may be obtained, from which the number of the busbars 7 with maximum power can be known. If costs (in units of RMB/W) of 10 to 19 busbars 7 are calculated under the diameter of the same electrode line 10, cost extreme values may also be obtained. It is appropriate that the number of the busbars 7 is within a range of the two.

In the present disclosure, the diameter of the electrode line and the number of the busbars of the solar module, the power of the solar module, and the costs of the solar module are studied as follows.

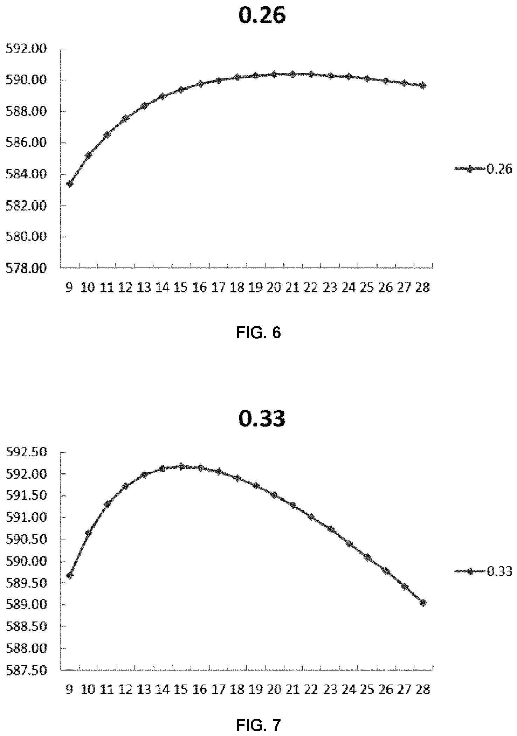

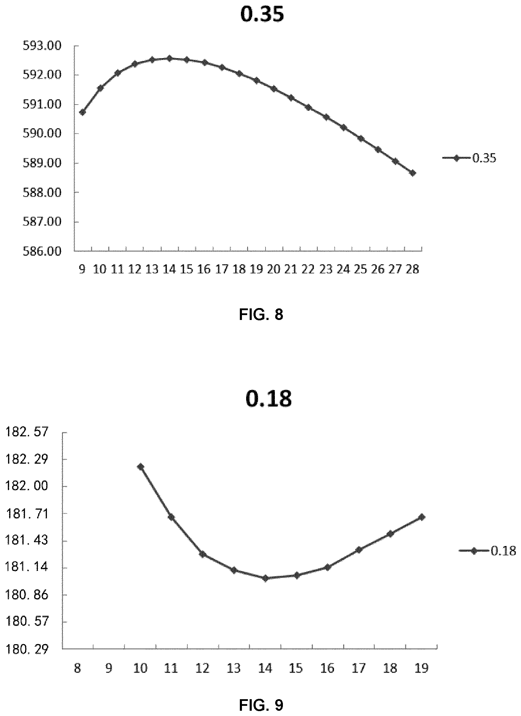

Referring to FIG. 5 to FIG. 8, FIG. 5 to FIG. 8 are diagrams of relations between the diameter of the electrode line, the number of busbars, and power of the solar module. In FIG. 5 to FIG. 8, the abscissa is the number of the busbars, and the ordinate is the power (W). In FIG. 5, when the diameter of the electrode line 10 is determined to be 0.18 mm, numbers of the busbars 7 are respectively set to 9, 10, 11, 12, 13, 14, 15, 16, 17, 18, 19, 20, 21, 22, 23, 24, 25, 26, 27, and 28 to measure the power of the solar module, and the power correspondingly obtained is respectively 541.16 W, 544.42 W, 547.00 W, 549.05 W, 550.73 W, 552.11 W, 553.27 W, 554.23 W, 555.04 W, 555.73 W, 556.31 W, 556.80 W, 557.22 W, 557.57 W, 557.87 W, 558.11 W, 558.32 W, 558.48 W, 558.61 W, and 558.71 W. In FIG. 6, when the diameter of the electrode line 10 is determined to be 0.26 mm, the numbers of the busbars 7 are respectively set to 9, 10, 11, 12, 13, 14, 15, 16, 17, 18, 19, 20, 21, 22, 23, 24, 25, 26, 27, and 28 to measure the power of the solar module, and the power correspondingly obtained is respectively 583.4 W, 585.19 W, 586.54 W, 587.57 W, 588.36 W, 588.95 W, 589.41 W, 589.76 W, 590 W, 590.19 W, 590.3 W, 590.37 W, 590.39 W, 590.37 W, 590.3 W, 590.22 W, 590.12 W, 589.98 W, 589.84 W, and 589.68 W. In FIG. 7, when the diameter of the electrode line 10 is determined to be 0.33 mm, the numbers of the busbars 7 are respectively set to 9, 10, 11, 12, 13, 14, 15, 16, 17, 18, 19, 20, 21, 22, 23, 24, 25, 26, 27, and 28 to measure the power of the solar module, and the power correspondingly obtained is respectively 589.68 W, 590.64 W, 591.3 W, 591.72 W, 591.99 W, 592.13 W, 592.17 W, 592.14 W, 592.05 W, 591.91 W, 591.74 W, 591.52 W, 591.28 W, 591.01 W, 590.73 W, 590.42 W, 590.10 W, 589.77 W, 589.42 W, and 589.06 W. In FIG. 8, when the diameter of the electrode line 10 is determined to be 0.35 mm, the numbers of the busbars 7 are respectively set to 9, 10, 11, 12, 13, 14, 15, 16, 17, 18, 19, 20, 21, 22, 23, 24, 25, 26, 27, and 28 to measure the power of the solar module, and the power correspondingly obtained is respectively 590.75 W, 591.56 W, 592.07 W, 592.37 W, 592.53 W, 592.58 W, 592.53 W, 592.43 W, 592.26 W, 592.04 W, 591.81 W, 591.53 W, 591.23 W, 590.90 W, 590.56 W, 590.21 W, 589.84 W, 589.46 W, 589.06 W, and 588.66 W. As can be seen, under the diameter of the same electrode line, as the number of the busbars increases, the maximum power increases first and then decreases, which is an inverted parabola trend. Any diameter of the electrode line between 0.18 mm and 0.35 mm is measured. When the power is maximum, the diameter of the electrode line and the number of the busbars conform to a condition y=116.55x²-92.03x+27.35, where x denotes the diameter of the electrode line.

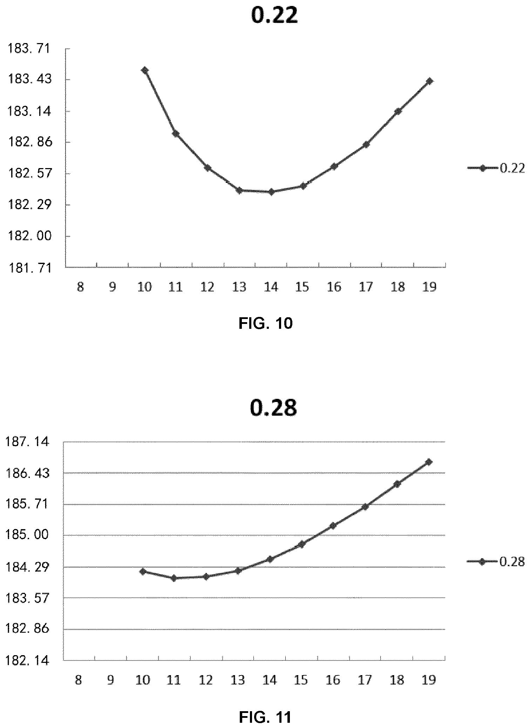

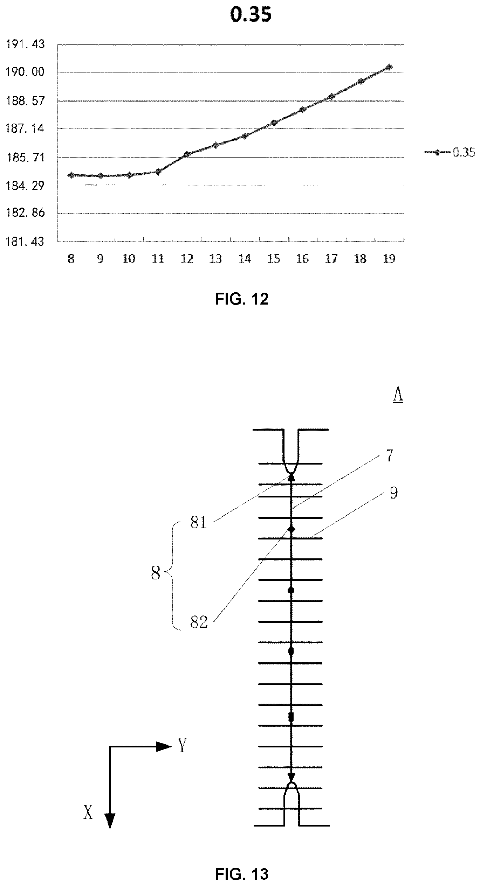

Referring to FIG. 9 to FIG. 12, the ratio of the cost to the predetermined reference cost is defined as a relative cost (which also applies to the description below) herein. FIG. 9 to FIG. 12 are diagrams of relations between the diameter of the electrode line, the number of busbars, and costs of the solar module. In FIG. 9 to FIG. 12, the abscissa is the number of the busbars, and the ordinate is the relative cost. In FIG. 9, when the diameter of the electrode line 10 is determined to be 0.18 mm, the numbers of the busbars 7 are respectively set to 10, 11, 12, 13, 14, 15, 16, 17, 18, and 19 to measure the costs of the solar module, and the corresponding relative costs of the solar module are respectively 182.20, 181.67, 181.29, 181.11, 181.03, 181.06, 181.14, 181.33, 181.50, or 181.67. In FIG. 10, when the diameter of the electrode line 10 is determined to be 0.22 mm, the numbers of the busbars 7 are respectively set to 10, 11, 12, 13, 14, 15, 16, 17, 18, and 19 to measure the costs of the solar module, and the corresponding costs of the solar module are respectively 183.51, 182.94, 182.63, 182.41, 182.40, 182.46, 182.64, 182.84, 183.14, or 183.41. In FIG. 11, when the diameter of the electrode line 10 is determined to be 0.28 mm, the numbers of the busbars 7 are respectively set to 10, 11, 12, 13, 14, 15, 16, 17, 18, and 19 to measure the costs of the solar module, and the corresponding relative costs of the solar module are respectively 184.19, 184.03, 184.07, 184.20, 184.47, 184.80, 185.21, 185.67, 186.19, or 186.67. In FIG. 12, when the diameter of the electrode line 10 is determined to be 0.35 mm, the numbers of the busbars 7 are respectively set to 10, 11, 12, 13, 14, 15, 16, 17, 18, and 19 to measure the costs of the solar module, and the corresponding relative costs of the solar module are respectively 184.81, 184.96, 185.89, 186.30, 186.77, 187.46, 188.13, 188.81, 189.56, or 190.27. As can be seen, under the diameter of the same electrode line, a maximum cost can be obtained. Any diameter of the electrode line between 0.18 mm and 0.35 mm is measured. When all cost values are minimum, the diameter of the electrode line and the number of the busbars conform to a condition y=582.75x²-425.59x+92.58, where x denotes the diameter of the electrode line.

It may be understood that, as shown in FIG. 4, an optimal number of the busbars 7 is between a closed pattern enclosed by two lines y=116.55x²-92.03x+27.35 and y=582.75x²-425.59x+92.58. The formulas of the present disclosure consider the number of the busbars with the maximum efficiency and the number of the busbars with the minimum cost, so a value between the two is taken to ensure that the power is high and the cost is not excessively high. That is, the relation between the diameter x of the electrode line 10 and the number y of the busbars 7 is 116.55x²-92.03x+27.35<y<582.75x²-425.59x+92.58. When this condition is satisfied, the number of the busbars 7 can be increased, the power of the solar module can be maximized, and the cost can be minimized.

In some embodiments, still referring to FIG. 1, a width of each of the busbars 7 is greater than or equal to 20 µm and less than or equal to 60 µm.

In this embodiment, the width of each of the busbars 7 refers to a width in a row direction (i.e., the second direction Y). In an embodiment, the width of each of the busbars 7 may be 20 µm, 30 µm, 40 µm, 50 µm, or 60 µm. It may be understood that the width of each of the busbars 7 is generally greater than 100 µm. In this embodiment, by reducing the width of a single busbar 7, the diameter of the electrode line 10 soldered with the busbars 7 can be reduced, and the costs can be reduced.

On the other hand, if the width of each of the busbars 7 is greater than or equal to 20 µm, soldering yield can be ensured. If the width of each of the busbars 7 is less than 20 µm, the soldering yield may be reduced. If the width of each of the busbars 7 is greater than 60 µm, consumption of silver paste may be increased in different degrees, and the costs may be increased. In this embodiment, the width of each of the busbars 7 being between 20 µm and 60 µm can ensure the soldering yield and required soldering tension. In addition, the consumption of silver paste of the busbar is reduced, and the number and area of the first electrode pads 8 thereon can also be reduced relatively, so that the consumption of silver paste can also be reduced and the costs can be further reduced.

In some embodiments, still referring to FIG. 3, the diameter of the electrode line 10 is greater than or equal to 0.18 mm and less than or equal to 0.35 mm.

In an embodiment, the diameter of the electrode line 10 may be 0.18 mm, 0.21 mm, 0.24 mm, 0.27 mm, 0.3 mm, 0.32 mm, or 0.35 mm. The diameter of the electrode line 10 is not specified herein, provided that the diameter is within a range greater than or equal to 0.18 mm and less than or equal to 0.35 mm. The diameter of the electrode line 10 being greater than or equal to 0.18 mm and less than or equal to 0.35 mm can maximize the power of the solar module and minimize the costs.

In some embodiments, referring to FIG. 13, FIG. 13 is a partially enlarged view of a region A in FIG. 2. The first electrode pad 8 is in the shape of one or combinations of a triangular shape, rectangular shape, diamond shape, circular shape, and oval shape.

FIG. 13 is only based on an example in which the shape of the first electrode pad 8 is a combination of a triangular shape, rectangular shape, diamond shape, circular shape, and oval shape.

In an embodiment, the first electrode pad 8 may be in the shape of one of rectangular shape, diamond shape, circular shape, oval shape, and a triangular shape, or combinations of two or more of rectangular shape, diamond shape, circular shape, oval shape, and a triangular shape. For example, the triangular shape is combined with any one of the rectangle, the diamond, the circle, and the oval. Such shapes can reduce the area of the first electrode pad 8 compared with a conventional square structure of the electrode pad. The design can reduce occlusion of a base, and can also reduce consumption of silver paste and the costs.

In some embodiments, still referring to FIG. 2 and FIG. 13, the one side of the semiconductor substrate 6 further includes fingers 9. The fingers 9 are electrically connected to the busbars 7 and intersect with the busbars at intersections.

The first electrode pad 8 includes first sub-electrode pads 81 and second sub-electrode pads 82, and the first sub-electrode pads 81 are located at ends of the busbars 7, and the second sub-electrode pads 82 are located between the first sub-electrode pads 81.

In an embodiment, the semiconductor substrate 6 further includes a plurality of fingers 9. The fingers 9 extend along a row direction and are arranged along a column direction, and the fingers 9 may intersect with the busbars 7. In an embodiment, the fingers 9 may be perpendicular to the busbars 7, the fingers 9 are electrically connected to the busbars 7, and the fingers 9 are configured to collect currents generated by the semiconductor substrate 6, which are then sunk to the busbars 7 and drawn from the busbars 7.

The first electrode pad includes first sub-electrode pads and second sub-electrode pads. The first sub-electrode pads may be located at harpoon shapes at two ends of each of the busbars 7. That is, the first sub-electrode pads may be arranged on two opposite sides of each of the busbars 7. The second sub-electrode pads are located between the first sub-electrode pads. Therefore, when the first sub-electrode pads are soldered successfully, positions of the busbars 7 and the electrode line 10 are also relatively fixed.

In some embodiments, still referring to FIG. 2 and FIG. 13, in a direction perpendicular to a plane of the semiconductor substrate, at least part of the second sub-electrode pads 82 do not overlap with the intersection.

It may be understood that the fingers 9 are electrically connected to the busbars 7 and intersect with the busbars at the intersection, and in a direction perpendicular to the plane of the semiconductor substrate 6, part of the second sub-electrode pads 82 do not overlap with the intersection. That is, the second sub-electrode pads are arranged on the busbars 7 and are not arranged at a junction between the busbars 7 and the fingers 9, which can reduce electrode breakage at joints between the busbars 7 and the fingers 9 caused by soldering, thereby affecting the yield of the solar module 100.

During actual manufacturing, part of the second sub-electrode pads 82 may overlap with the intersection. In an embodiment, the number of the second sub-electrode pads 82 not overlapping with the intersection is more than the number of the second sub-electrode pads 82 overlapping with the intersection. That is, most of the second sub-electrode pads 82 do not overlap with the intersection, which can ensure that the problem of electrode breakage can be alleviated to some extent.

In some embodiments, still referring to FIG. 1, a width of each of the busbars is the same as widths of the fingers 9.

It may be understood that, in the related art, the width of each of the busbars 7 is greater than the widths of the fingers 9. However, in this embodiment, the width of each of the busbars 7 is reduced, so that the width of each of the busbars 7 is the same as the widths of the fingers 9. In this way, the consumption of silver paste can be reduced and the costs can be reduced by reducing the width of each of the busbars 7.

In some embodiments, still referring to FIG. 2, the semiconductor substrate is an N-type substrate or a P-type substrate.

In an embodiment, if the semiconductor substrate 6 is the N-type substrate, the solar cell 3 is an N-type solar cell 3. If the semiconductor substrate 6 is the P-type substrate, the solar cell 3 is a P-type solar cell 3. The N-type substrate conducts electricity through electrons, while the P-type substrate conducts electricity through holes.

Silver paste is provided on two sides of the front surface 31 and the rear surface 32 of the N-type solar cell 3. In a possible embodiment, the N-type solar cell 3 may be a Tunnel Oxide Passivated Contact (TOPCon) solar cell. A substrate of the TOPCon solar cell is an N-type substrate.

The P-type solar cell 3 is provided with silver paste on one side and aluminum paste and silver paste on the other side. In a possible embodiment, the P-type solar cell 3 may be a Passivated Emitter and Rear Cell (PERC) solar cell. A substrate of the PERC solar cell is a P-type substrate.

It may be understood that the N-type solar cell 3 has a longer service life and higher efficiency, while the P-type solar cell 3 has a simpler process and lower costs. The semiconductor substrate 6 is not specified in the present disclosure.

In some embodiments, still referring to FIG. 13, lengths of the first sub-electrode pads 81 in the first direction X are greater than or equal to 0.5 mm and less than or equal to 0.8 mm, widths of the first sub-electrode pads 81 in the second direction Y are greater than or equal to 0.5 mm to 1.2 mm, lengths of the second sub-electrode pad 82 in the first direction X are greater than or equal to 0.05 mm and less than or equal to 0.5 mm, widths of the second sub-electrode pads 82 in the second direction Y are greater than or equal to 0.4 mm and less than or equal to 0.8 mm, the first direction X is parallel to an extension direction of the electrode line 10, and the second direction Y is perpendicular to the extension direction of the electrode line 10.

It may be understood that the first sub-electrode pads 81 at the ends of the busbar 7 are required to be soldered with the electrode line 10, so areas of the first sub-electrode pads 81 may be set to be larger than areas of the second sub-electrode pads 82, which can ensure the electrical connection with the electrode line 10 and prevent failure of the soldering.

Herein, the first direction X is a column direction and parallel to the extension direction of the electrode line 10, and the second direction Y is a column direction and perpendicular to the extension direction of the electrode line 10.

In some embodiments, lengths of the first sub-electrode pads 81 and the second sub-electrode pads 82 in the first direction X and the second direction Y cannot be excessively small or excessively large. If the lengths are excessively small, the soldering with the electrode line 10 may be affected. If the lengths are excessively large, light may be occluded, the power may be reduced, and the amount of silver paste may also be increased. In an embodiment, the lengths of the first sub-electrode pads 81 in the first direction X may be 0.5 mm, 0.6 mm, 0.7 mm, or 0.8 mm, the widths of the first sub-electrode pads 81 in the second direction Y may be 0.5 mm, 0.6 mm, 0.7 mm, 0.8 mm, 0.9 mm, 1.0 mm, 1.1 mm, or 1.2 mm, the lengths of the second sub-electrode pads 82 in the first direction X may be 0.05 mm, 0.1 mm, 0.2 mm, 0.3 mm, 0.4 mm, or 0.5 mm, and the widths of the second sub-electrode pads 82 in the second direction Y may be 0.4 mm, 0.5 mm, 0.6 mm, 0.7 mm, or 0.8 mm.

Compared with the related art, in this embodiment, sizes of the first sub-electrode pad 81 and the second sub-electrode pad 82 are both reduced to reduce occlusion of light, increase the power, reduce the amount of silver paste, and reduce the costs.

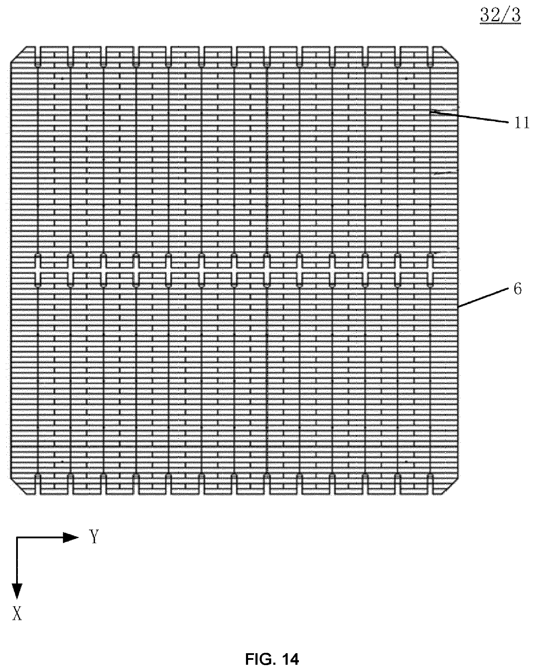

In some embodiments, referring to FIG. 14, FIG. 14 is a schematic diagram of a plane structure of a rear surface of the solar cell according to the present disclosure. The semiconductor substrate 6 is the P-type substrate, second electrode pads 11 are provided at the busbars 7 on the rear surface 32, a number of the second electrode pads 11 ranges from 6 to 10, lengths of the second electrode pads 11 in the first direction X are greater than or equal to 1 mm and less than or equal to 2 mm, widths of the second electrode pads 11 in the second direction Y are greater than or equal to 2 mm and less than or equal to 3 mm, the first direction X is parallel to an extension direction of the electrode line 10, and the second direction Y is perpendicular to the extension direction of the electrode line 10.

Silver paste is adopted on the front surface 31 of the P-type substrate, while aluminum paste and silver paste are adopted on the rear surface 32 of the P-type substrate. For the rear surface 32 of the P-type substrate, the number of the second electrode pads 11 may be less than that of the N-type substrate. In this embodiment, the number of the second electrode pads 11 on the rear surface 32 of the P-type substrate ranges from 6 to 10, which may be, for example, 6, 7, 8, 9, or 10 and is not specified herein.

Similarly, the size of the second electrode pad 11 cannot be excessively small or excessively large. If the lengths are excessively small, the soldering with the electrode line 10 may be affected. If the lengths are excessively large, the consumption of aluminum paste and silver paste may be increased. In an embodiment, the lengths of the second electrode pads 11 in the first direction X are greater than or equal to 1 mm and less than or equal to 2 mm, which may be, for example, 1 mm, 1.2 mm, 1.4 mm, 1.6 mm, 1.8 mm, or 2 mm, and the widths of the second electrode pads 11 in the second direction Y may be greater than or equal to 2 mm and less than or equal to 3 mm, which may be, for example, 2 mm, 2.2 mm, 2.4 mm, 2.6 mm, 2.8 mm, or 3 mm. In this embodiment, the soldering with the electrode line 10 can be ensured without increasing the consumption of aluminum paste and silver paste.

In some embodiments, still referring to FIG. 1, the semiconductor substrate 6 is the N-type substrate, and a number of the fingers 9 is greater than or equal to 76 and less than or equal to 98; and widths of the fingers 9 are greater than or equal to 20 µm to 30 µm; or
the semiconductor substrate 6 is the P-type substrate, and a number of the fingers 9 is greater than or equal to 90 and less than or equal to 120; and widths of the fingers 9 are greater than or equal to 20 µm to 30 µm.

It may be understood that silver paste is used on both the front surface 31 and the rear surface 32 of the N-type substrate, while silver paste is used on the front surface 31 of the P-type substrate, and aluminum paste and silver paste are used on the rear surface 32 of the P-type substrate. Therefore, when the semiconductor substrate 6 is the P-type substrate, the number of the fingers 9 thereof is different from the number of the fingers 9 of the N-type substrate.

In an embodiment, the semiconductor substrate 6 is the N-type substrate, and the number of the fingers 9 is greater than or equal to 76 and less than or equal to 98; and the widths of the fingers 9 are greater than or equal to 20 µm to 30 µm. For example, the number of the fingers 9 may be 76, 80, 85, 90, 93, 96, or 98, and the widths of the fingers 9 may be 20 µm, 22 µm, 26 µm, 28 µm, or 30 µm. Compared with the related art, in this embodiment, by reducing the number of the fingers 9, the consumption of the silver paste can be reduced, the costs can be reduced, and occlusion caused by the fingers 9 can also be reduced.

In an embodiment, the semiconductor substrate 6 is the P-type substrate, and the number of the fingers 9 is greater than or equal to 90 and less than or equal to 120; and the widths of the fingers 9 are greater than or equal to 20 µm to 30 µm. For example, the number of the fingers 9 may be 90, 95, 100, 105, 110, 115, or 120, and the widths of the fingers 9 may be 20 µm, 22 µm, 26 µm, 28 µm, or 30 µm. Compared with the related art, in this embodiment, by reducing the number of the fingers 9, the consumption of the silver paste can be reduced, the costs can be reduced, and occlusion caused by the fingers 9 can also be reduced.

In some embodiments, still referring to FIG. 1, the solar module further includes a front sheet 1, a first encapsulation layer 2, a second encapsulation layer 4, a back sheet 5, and a connection structure. The solar cells 3 are located between the first encapsulation layer 2 and the second encapsulation layer 4, and the solar cells 3 are respectively connected to the first encapsulation layer 2 and the second encapsulation layer 4 through the connection structure.

The connection structure is not shown in FIG. 1. In an embodiment, the connection structure may be a transparent double-sided adhesive, which is not specified herein.

As can be seen from FIG. 1, the solar cells 3 are located between the first encapsulation layer 2 and the second encapsulation layer 4. In an embodiment, the first encapsulation layer 2 and the second encapsulation layer 4 may be made of ethylene vinyl acetate (EVA), polyethylene-octene elastomer (POE), or EVA and POE integrated co-extrusion materials, which are not specified herein. POE has no acidic group in a molecular structure, and has a better water vapor barrier than EVA, which has a better protective effect on the solar cell 3. However, compared with EVA, raw material and process costs of POE are significantly increased. The current industry uses POE instead of EVA for packaging, which significantly increases packaging costs of the solar module 100, and is not conducive to reduction of costs of photovoltaic power generation. EVA has low costs, but EVA has acid groups in a molecular structure. In high temperature and humidity environments, corrosion materials such as acetic acid may be generated after degradation, which may corrode the electrode line 10 and the paste of the busbars on the solar cell 3, and affect collection and output of currents of the module, thereby leading to power attenuation of the module and reduction of power generation capability.

In some embodiments, still referring to FIG. 1 and FIG. 2, the semiconductor substrate 6 of the solar cell 3 is an N-type substrate, and the first encapsulation layer 2 and/or the second encapsulation layer 4 has an area density greater than or equal to 250 g/m² and less than or equal to 500 g/m²; or the semiconductor substrate 6 of the solar cell 3 is a P-type substrate, and of the first encapsulation layer 2 and/or the second encapsulation layer 4 has an area density greater than or equal to 250 g/m² and less than or equal to 400 g/m².

It may be understood that silver paste is used on both the front surfaces 31 of the N-type substrate and the P-type substrate, so weights of the first encapsulation layers 2 of the N-type substrate and the P-type substrate may be equal. However, aluminum paste and silver paste are used on the rear surface 32 of the P-type substrate, while silver paste is used on the rear surface 32 of the N-type substrate, so weights of the second encapsulation layers 4 of the N-type substrate and the P-type substrate are not equal.

It may be understood that, if a gram weight of the first encapsulation layer 2 or the second encapsulation layer 4 is excessively large, the costs may be increased, and if the gram weight is excessively small, the solar cell 3 cannot be effectively packaged and protected. In this embodiment, the semiconductor substrate 6 of the solar cell 3 is an N-type substrate, and the first encapsulation layer 2 and/or the second encapsulation layer 4 has an area density greater than or equal to 250 g/m² and less than or equal to 500 g/m²; or the semiconductor substrate 6 of the solar cell 3 is a P-type substrate, and the first encapsulation layer 2 and/or the second encapsulation layer 4 has an area density greater than or equal to 250 g/m² and less than or equal to 400 g/m². Compared with the related art, the gram weights of the first encapsulation layer 2 and the second encapsulation layer 4 are reduced. In the present disclosure, the diameter of the electrode line 10 is reduced, which is conducive to reduction of the gram weights of the first encapsulation layer 2 and the second encapsulation layer 4, so that the first encapsulation layer 2 and the second encapsulation layer 4 with lower gram weights can be selected when the solar module 100 is packaged, and can package and protect the solar cell 3 at the same time. In this embodiment, packaging costs of solar module 100 can be reduced on the premise of ensuring reliability of the solar module 100.

As can be known from the above embodiments, the solar module according to the present disclosure achieves at least the following beneficial effects.

The present disclosure can balance costs and power of the photovoltaic module. On the one hand, the costs are reduced by reducing the diameter of the electrode line, because gram weights of the first encapsulation layer and the second encapsulation layer can be reduced after the diameter of the electrode line is reduced. However, the reduction of the diameter of the electrode line may lead to reduction of a cross-sectional area of current transmission, that is, reduction of the power, so there is a need to increase the number of the electrode line and the number of the busbars. On the other hand, the power of the solar module is increased by increasing the number of the busbars. However, the number of the busbars and the power are not in a linear relationship, that is, the power of the solar module does not increase as the number of the busbars increases, but the power may decrease after the number is increased to an extreme value. This is because the increase in the number of the busbars causes excessive occlusion of light. If a decrease in the occlusion is greater than an increase in the current transmission, the power may be reduced. In the present disclosure, the relation between the diameter x of the electrode line and the number y of the busbars is 116.55x²-92.03x+27.35<y<582.75x²-425.59x+92.58. When the condition is satisfied, the number of the busbars can be increased, losses caused by a large-size current can be reduced, and the costs can be reduced.

Although some specific embodiments of the present disclosure have been described in detail through examples, it should be understood by those skilled in the art that the above examples are for illustrative purposes only and not intended to limit the scope of the present disclosure. It should be understood by those skilled in the art that the above embodiments can be modified without departing from the scope and spirit of the disclosure. The scope of the present disclosure is defined by the appended claims.

## Claims

1. A solar module, comprising:
solar cells,
wherein each of the solar cells has a front surface and a rear surface arranged opposite to each other, and comprises a semiconductor substrate and busbars located on one side of the semiconductor substrate,
wherein first electrode pads are provided at the busbars, and a number of the first electrode pads ranges from 6 to 12;
wherein the solar module further comprises an electrode line, wherein the electrode line comprises an end connected to the first electrode pads of the busbars on the front surface of one solar cell of the solar cells, and another end connected to the first electrode pads of the busbars on the rear surface of another one solar sheet of the solar cells that is adjacent to the one solar sheet; and
wherein a relation between a diameter of the electrode line and a number of the busbars is 116.55x²-92.03x+27.35<y<582.75x²-425.59x+92.58, where x denotes the diameter of the electrode line, and y denotes the number of the busbars.

2. The solar module according to claim 1, **characterized in that** a width of each of the busbars is greater than or equal to 20 µm and less than or equal to 60 µm.

3. The solar module according to claim 1, **characterized in that** the diameter of the electrode line is greater than or equal to 0.18 mm and less than or equal to 0.35 mm.

4. The solar module according to claim 1, **characterized in that** each of the first electrode pads has any shape including triangular shape, rectangular shape, diamond shape, circular shape, and oval shape, or a combination thereof.

5. The solar module according to claim 1,
**characterized in that** fingers are provided at one side of the semiconductor substrate, and the fingers are electrically connected to the busbars and intersect with the busbars at intersections; and
wherein the first electrode pads comprise first sub-electrode pads and second sub-electrode pads, wherein each of the first sub-electrode pads is located at an end of one of the busbars, and the second sub-electrode pads are located between the first sub-electrode pads.

6. The solar module according to claim 5, **characterized in that** in a direction perpendicular to a plane of the semiconductor substrate, at least part of the second sub-electrode pads do not overlap with the intersection.

7. The solar module according to claim 5, **characterized in that** the number of the second sub-electrode pads not overlapping with the intersection is more than the number of the second sub-electrode pads overlapping with the intersection.

8. The solar module according to claim 5, **characterized in that** a width of each of the busbars is the same as a width of each of the fingers.

9. The solar module according to claim 5, **characterized in that** the semiconductor substrate is an N-type substrate or a P-type substrate.

10. The solar module according to claim 9, **characterized in that** a length of each of the first sub-electrode pads in a first direction is greater than or equal to 0.5 mm and less than or equal to 0.8 mm, a width of each of the first sub-electrode pads in a second direction is greater than or equal to 0.5 mm and less than or equal to 1.2 mm, a length of each of the second sub-electrode pads in the first direction is greater than or equal to 0.05 mm and less than or equal to 0.5 mm, and a width of each of the second sub-electrode pads in the second direction is greater than or equal to 0.4 mm and less than or equal to 0.8 mm,
wherein the first direction is parallel to an extension direction of the electrode line, the second direction is perpendicular to the extension direction of the electrode line.

11. The solar module according to claim 9, **characterized in that** the semiconductor substrate is the P-type substrate, and each of the busbars on the rear surface is provided with second electrode pads, and a number of the second electrode pads range from 6 to 10,
wherein a length of each of the second electrode pads in a first direction is greater than or equal to 1 mm and less than or equal to 2 mm, a width of each the second electrode pads in a second direction is greater than or equal to 2 mm and less than or equal to 3 mm, and the first direction is parallel to an extension direction of the electrode line, the second direction is perpendicular to the extension direction of the electrode line.

12. The solar module according to claim 10 or 11, **characterized in that** areas of the first sub-electrode pads 81 are set to be larger than areas of the second sub-electrode pads 82.

13. The solar module according to claim 9, **characterized in that**
the semiconductor substrate is the N-type substrate, and a number of the fingers is greater than or equal to 76 and less than or equal to 98; and widths of the fingers are greater than or equal to 20 µm to 30 µm; or
the semiconductor substrate is the P-type substrate, and a number of the fingers is greater than or equal to 90 and less than or equal to 120; and widths of the fingers are greater than or equal to 20 µm to 30 µm.

14. The solar module according to claim 1, further comprising a front sheet, a first encapsulation layer, a second encapsulation layer, a back sheet, wherein the solar cells are located between the first encapsulation layer and the second encapsulation layer,.

15. The solar module according to claim 14, **characterized in that**
the semiconductor substrate of the solar cell is an N-type substrate, and the first encapsulation layer and/or the second encapsulation layer has an area density greater than or equal to 250 g/m² and less than or equal to 500 g/m²; or
the semiconductor substrate of the solar cell is a P-type substrate, and the first encapsulation layer and/or the second encapsulation layer has an area density greater than or equal to 250 g/m² and less than or equal to 400 g/m².
